# EUROPEAN PATENT APPLICATION

(11) **EP 1 581 034 A1**
(43) Date of publication of application: **28.09.2005**
(21) Application number: 04075897.1
(22) Date of filing: 25.03.2004
(51) Int. Cl.: H05K 3/34, H05K 3/28, G03F 7/16

(54) **Method of forming solder mask**

(71) Applicant: DSM IP Assets B.V., 6411 TE Heerlen (NL)
(72) Inventor: Misev, Tosko Alexandar, 60540 Naperville Illinois (US); Binda, Paul Herman Guillame, 8032 TB Zwolle (NL); Bratslavsky, Svetlana Alexandra, 60120 Elgin Illinois (US)
(74) Representative: Renkema, Jaap

(57) **Abstract**

The invention relates to a method of forming a solder mask on a printed circuit board using a powder paint composition, which method comprises the steps of
- a: charging powder paint particles in the presence of carrier particles
- b: feeding the charged powder paint particles with carrier particles to a transporter
- c: optionally transferring the charged powder paint particles from the transporter onto a transfer medium
- d: applying the powder paint particles to a printed circuit board to form a layer of powder paint particles
- e: irradiating the layer by subjecting the layer to ultra violet irradiation through a pattern mask to obtain partial or full cure of the exposed powder paint particles
- f: developing the layer with a medium which dissolves the region not irradiated by the ultraviolet rays.

## Description

The present invention relates to a method of forming a solder mask on a printed circuit board (PCB).

A solder mask is formed on conductor circuits of a printed circuit board for ensuring insulation between the conductor circuits, for protecting the conductor circuits from peeling or oxidation, and/or for preventing unnecessary solder from sticking on the conductor circuits at the time of soldering operation.

Methods of forming a solder mask on a printed circuit board are known in the art.

For example, a screen printing process is typically well-known. However, the screen printing process provides substantially low resolution. It develops defects like blur, pinholes, bleed, spread or the like, resulting in failure to deal with diminishing distances between conductor circuits or increasing densities of the printed circuit board that has taken place concomitant with the recent high density mounting of circuits.

US 4,230,793 describes a method, wherein a printed circuit board is coated with a solution of a photopolymer by applying curtain coating technology. The solvent is removed, the photopolymer is subsequently cured with ultraviolet light through a mask, whereby the photopolymer allocated in the positions of the PCB that need to be soldered remains uncured, and can be developed and dissolved.

The use of liquids has a number of disadvantages. For example, the thickness of the solder mask is rather thin, whereby the proper amount of electric insulation, heat resistance and resistance to organic solvents, etc., cannot be obtained. If the substrate has any through-holes, the photosensitive composition flows into these through holes and gives rise to various problems.

EP 0 541 111 describes a method of forming a solder mask by using a powder paint. The powder paint is applied to the PCB at a temperature above the softening point of the powder paint to form a coating of powder paint, the coating is irradiated with UV-light through a pattern mask, the coating is developed with a medium which dissolves the region not irradiated by the UV rays, and the remaining irradiated portion of the coating on the printed circuit board is cured at a temperature higher than the curing temperature of the powder paint.

The use of a powder paint known sofar is restricted to powder paints that need to be UV cured in a first step, followed by a lengthy thermal postcure step. Moreover application of the powder on the PCB is slow and turns out to be difficult in practice.

One object of the present invention is to provide an improved method for applying a uniform layer of powder paint particles on a printed circuit board.

The invention provides a method of forming a solder mask on a printed circuit board using a powder paint composition, which method comprises the steps of
a charging powder paint particles in the presence of carrier particles
b feeding the charged powder paint particles with carrier particles to a transporter
c optionally transferring the charged powder paint particles from the transporter onto a transfer medium
d applying the powder paint particles to a printed circuit board to form a layer of powder paint particles
e irradiating the layer by subjecting the layer to ultra violet irradiation through a pattern mask to obtain partial or full cure of the exposed powder paint particles
f developing the layer with a medium which dissolves the region not irradiated by the ultraviolet rays.

The method may also contain a step of
g optionally completely curing the remaining irradiated portion of the layer on the printed circuit board at a temperature higher than the curing temperature of the powder paint composition.

A preferred embodiment of the present invention is the process, wherein the method comprises a step e, which is
e heating the layer to a temperature above the glass-transition temperature of the powder paint particles and irradiating the layer by subjecting the layer to ultra violet irradiation through a pattern mask to obtain partial or full cure of the exposed powder paint particles.

The method of the invention shows the advantage of application of a very uniform layer of powder paint particles on the substrate that contains both conducting and non-conducting parts. The method can be applied to flexible and rigid printed circuit boards. The method can be much faster than methods known to date.

Another preferred embodiment of the present invention is the method, wherein step e comprises heating the layer to a temperature above the glass-transition temperature of the powder paint particles, partially curing of the layer of powder paint particles to a level whereby it becomes tack free, applying a photo mask on the layer of partially cured powder coating layer, irradiating the layer by subjecting the layer to ultra violet irradiation through a pattern mask to obtain partial or full cure of the exposed powder paint particles. Advantage of this method is, that the photo mask can be applied to the PCB containing a layer of powder particles, whereby no contamination of the photo mask occurs. The photo mask can be used many times, and a pattern with a high resolution can be obtained.

A printed circuit board (PCB) is a material that contains a dielectric core that has been coated or impregnated with resin. The dielectric material is usually woven glass fibers or paper. Different combinations of these two materials and the substitution of various resin systems can alter the electrical, physical, performance and cost characteristics of the material. The type of material employed for a specific purpose depends on the function of the PCB, design requirements and how it will be manufactured. FR4 is the designation given to the most widely used material for the PCB industry. It is constructed of multiple plies of epoxy resin-impregnated woven glass cloth.

In a next step of the PCB production process, the base laminate is coated with copper by either electrolytic deposition or by laminating a resin coated cupper foil onto the base laminate. In a consecutive step a printed circuitry is generated on the board by the print and etch method.

The present invention describes an improved method of applying a solder mask layer on the printed circuitry as a protective layer. The solder mask is applied on the entire surface of the PCB, except where soldering is expected to occur during the assembly operation.

Powder paint particles are particles that have a glass transition temperature above room temperature, and that can be cured to, for example, a coating layer by ultraviolet radiation or heat. The glass transition temperature typically lies in the range between 40 and 140 °C. The powder paint particles generally include an oligomer or polymer having functional groups that can react to form a polymeric structure. The reaction may for example be a radical polymerization reaction or a cationic polymerization reaction. The functional groups may be unsaturated groups, like for example vinylether, acrylate, methacrylate, or cationically curable groups like for example epoxy, oxetane.

Examples of suitable polymers include unsaturated polyesters, unsaturated polyacrylates, acrylated polyesters, bisphenol A or F type epoxy resins, brominated epoxyresins, dicyclopentadiene phenolic resin and novolac type epoxy resins, saturated carboxylated polyester resin/triglycidylisocyanurate (TGIC), unsaturated acrylic resin/vinylether, unsaturated polyester resin/vinylether. The median particle size (by volume) of the powder paint particles X_{50,3} (as defined according to the description and notation at pages 12-14 of Mechanische Verfahrenstechnik by Prof. Rumpf (Carl Hansen Verlag, 1975)) can be for example below about 200 µm, and preferably, is between about 5 and about 60 µm.

Characteristics of powder paint particles, the methods to make the particles, the way of application etc can be found in Misev, Powder Coatings, Chemistry and Technology Wiley 1991, the disclosure of which is incorporated herein by reference.

Powder paint compositions and methods to make powder paint compositions are also disclosed in for example US 6,342,273, the complete disclosure of which is incorporated herein by reference. This reference also describes the process of charging powder paint particles and the application to substrates like metal, textile, plastic, wood, board or paper-like materials. It also teaches that pretreatment of the substrates is important.

US 6,342,273 does not teach the coating of powder paint particles of PCB substrates. PCB substrates have the additional difficulty that they possess both highly conductive parts and regions with non-conductivity.

The process of the present invention also applies carrier particles. Carrier particles can be either magnetic or non-magnetic. Preferably, the carrier particles are magnetic particles.

Suitable magnetic carrier particles have a core of, for example, iron, steel, nickel, magnetite, γ-Fe₂O₃, or certain ferrites such as for example CuZn, NiZn, MnZn and barium ferrites. These particles can be of various shapes, for example, irregular or regular shape.

Generally, these carrier particles have a median particle size between 20 and 700 µm. Preferably, the carrier particle size distribution is narrow and more preferably the ratio X_{75,3} :X_{25,3} <2.

Exemplary non-magnetic carrier particles include glass, non-magnetic metal, polymer and ceramic material.

Non-magnetic and magnetic carrier particles can have similar particle size.
For direct application without a transfer medium, on a metal substrate, the carrier particles should be preferably non-conductive and they should have a well-defined high resistivity of, for example, 10⁹-10¹¹ Ohm at 10V potential and a break-through voltage above 1,000V (measured with a c-meter supplied by Epping GmbH).

In case of use of a transfer medium the carrier particles can be conductive or non-conductive.

Preferably, carrier particles having high voltage break through are used so hat high electric fields can be used between transport means and substrate or transfer media to achieve a thick powder layer.

A developer comprises powder paint particles and carrier particles. A development method is a way of developing and a development unit is a complete system comprising of, for example, a developer roller (transport medium), mixing screw(s), a supply device, blades, detectors and the like. Other examples are described in, for example, GB-A-2097701, U.S. Pat. No. 4,147,127 and U.S. Pat. No. 4,131,081.

In the present invention the development method can be either one-component or two-component. According to a preferred embodiment of the invention the two-component development method, in which the carrier particles are mixed with the powder paint particles, is used. Alternatively, also all kinds of mono component development like, for example, magnetic conductive, magnetic insulative or non magnetic development as disclosed on pages 203 ff of L.B. Schein (Electrography and, Development Physics, pages 32-244, Volume 14, Springer Series in Electrophysics 1988: the disclosure of which is incorporated herein by reference) or binary developers consisting of e.g. magnetic toner and carrier as described in U.S, Pat. No. 5,516,613 can be used.

Preferably, a combination of powder paint particles having a X_{50,3} below 80 µm and a X_{95,3} below 120 µm and carrier particles having a X_{50,3} below 180 µm and a X_{95,3} below 200 µm is used.

In the two-component developer the amount of powder paint particles can be, for example, between about 1 and about 50 wt. % and preferably between about 5 and about 25 wt. % (relative to the amount of developer). It is an advantage of the process according to the invention that it is possible to use powder paint concentrations well in excess of 10 wt. %. Consequently, the amount of carrier particles can be between about 50 and about 99% by weight (relative to the amount of developer) and preferably is between about 75 wt. % and about 95 wt. %.

The powder paint concentration can be externally or internally (in the development unit) controlled. External control can be effected by measurement of layer thickness of uncured or cured powder by, for example, optical, photothermical or dielectrical means. Internal control car be carried out in the developer station by means of powder paint concentration control by any suitable means like inductive control (see, for example, U.S. Pat. No. 4,147,127 and U.S. Pat. No. 4,131,081) or volume control.

In a two-component development method the powder paint particles are triboelectrically charged by intensive mixing and friction with the carrier particles.

A preferred process according to the present invention thus comprises charging of the powder paint particles by intensive mixing and friction with magnetic carrier particles, transport of carrier particles and powder paint particles with the aid of a magnetic roller and subsequent application of the powder paint particles to a substrate by means of an electric field between the substrate and the magnetic roller.

The coating may cover the full area of the substrate or only part of it (spot coating). In case of spot coating any image creating technology as described in the above mentioned Schein may be used to create an image on a suitable transfer medium or as first transfer medium in case of two step transfer as described before.

The carrier particles may be dosed to a mixing arrangement in which one or more means of intensive mixing such as, for example, worm wheels are present along with a magnetic roller. Suitable mixing arrangements are described in, for example, "Proceeding of IS&T's Seventh International Congress on "Advances in Non Impact Printing Technologies", Vol. 1, pages 259-265, the complete disclosure of which is herein incorporated by reference.

Next, an amount of powder paint particles is fed into the mixing arrangement which is selected so as to obtain a powder paint particles concentration of, for example, about 5-15 wt. % powder paint relative to the amount of carrier particles. In this way, a developer is formed.

During the intensive mixing and friction in the mixing arrangement, due to the action of the worm weels, the carrier particles and the powder paint particles become oppositely (tribo) electrically charged. A layer of electrically charged powder paint particles covers the carrier particles. The carrier particles subsequently act as carrier for the charged powder paint particles. Next, the developer is fed to the magnetic roller, in which a brush-like structure, also known as the magnetic brush, is formed. The magnetic roller transports the brush to the contact area with the substrate or transfer medium. In this way, powder paint particles, as well as carrier particles, become available at the contact area with the substrate or transfer medium. By applying a sufficiently strong electric field between the magnetic roller and the substrate or transfer medium the powder paint particles can be drawn from the brush to the substrate or transfer medium, onto which they adhere electrostatically. In the case a transfer medium is used, the powder paint particles are subsequently transported to the contact area of the transfer medium and the substrate and next transferred to the substrate via one of the aforementioned transfer processes.

Finally, the magnetic brush is scraped off the magnetic roller as it is returned into the mixing bin.

As a result, a layer of powder paint particles forms on the substrate, which layer is substantially free from carrier particles, and can then be cured. Eventually an apparatus which can catch carrier particles can be introduced such as for example a catching equipment for residual carrier, as described in "Proceeding of IS&T Eighth International Congress on Advances in Non Impact Printing Technologies", pages 391-393. The thickness of said layer of powder paint particles can, for example, be controlled via the electric field strength between the magnetic roller and the substrate, or the transfer medium, the magnitude of the charge on the powder paint particles (e.g. by varying the concentration and the mixing time) and the roller speed.

Depending on the conductivity of the substrate the electric field between the substrate and the transfer medium or means of transport can be applied with suitable methods like for instance a corona discharge or a moving or fixed counterelectrode (see for instance Schein, pp. 36-37 and 47).

Pretreatment of the PCB may be preferred, in case the conductivity differences are too large on the PCB. Pretreatment may be very simple, like wetting the surface of the PCB with a polar substance, like for example water or alcohols and ketones etc. with for instance a soaked cloth. The obtained increased surface conductivity will increase the thickness of the applied layer of powder coatings as electrostatically applied from the magnetic brush unit.
Another way to increase the amount of powder coatings as applied from the magnetic brush unit is by applying charge to the PCB with a corona discharge device. The applied charge facilitates powder application when this charge is opposite to the charge of the powder paint particles from the magnetic brush unit.

Surprisingly it has been found that flexible PCB's do not need any pretreatment as described above, and can be coated with a layer of powder paint particles without pretreatment.

After application of the powder onto the PCB, the layer is irradiated with ultraviolet radiation through a pattern mask. Parts of the layer that have been irradiated, will partially or fully cure. Parts of the layer of powder particles that have not been irradiated can easily be developed or dissolved with suitable solvents , like aceton, methylethylketon, cyclohexanon, methanol, ethanol, water alkaline solutions, supercritical carbon dioxide, trichloroethane, and the like.

As a result, a PCB is obtained having a printed circuitry, which is covered with a solder mask, except for the places where soldering action needs to be performed.

The solder mask may be further cured if necessary with either UV-irradiation and or heat.

### Examples

### Example 1

### Powder preparation

A powder solder mask composition was prepared by premixing of 790 g of unsaturated polyester, Uralac ZW 3125 (DSM Resins), 160 g of vinyl ether Uralac ZW3307 (DSM Resins), 22 g of photoinitiator Lucirin TPO (BASF), 22 g of photoinitiator Irgacure-819 (Ciba), 6 g of surfactant BYK-361 (BYK Chemie),), 5 g of benzoin (GCA Chemical) as a degassing agent.

After the components were mixed, the mixture was extruded on a Prism Extruder at 168°C at 200 RPM. Het is beter om de gegevens uit de leaflet van dit product te halen! After cooling, the extrudate was milled first in a hammer mill to a particle size < 3 mm and then fed into a fluidized bed mill (Condux CFS8), having a nozzle diameter of 4 mm. The material was milled with 5 bar air overpressure at 1900 rpm of the classifier wheel incorporated in the mill obtaining a powder with a median particle size of 24 µm and a X_{75,3}/X_{25,3} ratio of 2.3.

### Example 2

### Preparation of a Carrier

992 parts by weight Cu-Zn-ferrite powder, having a median particle size of 55 µm and a ratio X_{75,3}/X_{25,3} of 1,32 (both measured with the laser granulometer Cilas HR 850), were dry coated with 8 parts by weight polyvinylidenedifluoride (Kynar 301F™) by mixing both materials in a Lödige mixer and coating the polymer on the surface of the ferrite in a rotary kiln at 200°C under Nitrogen to obtain a carrier with a median size of 55 µm, a ratio X_{75,3}/X_{25,3} of 1.32, a resistance of 1.1*10¹⁰ Ohm at a potential of 10V and a break-through voltage above 1,000V (both measured in a c-meter of Epping GmbH).

### Example 3

### Coating on a PCB substrate

A 500 gram mixture or developer of 25% by weight of the powder composition made according to Example I and 75% by weight of the carrier according to Example II were brought into a magnetic brush unit available as the LD-tester (developer life time tester) from Epping GmbH, mounted at a distance of 3 mm of a rotating rubber coated metal drum. The rubber coating on the drum is available from Ruma, Hoogeveen, NL product code: 607-50. The rubber is coated with an anti-stick coating: product code Rumacoat 101F).

The developer was mixed in the LD-tester for 1 minute at a rotating speed setting of 90, which is equivalent to 150 RMP or a surface speed of the drum of 57 m/min. The charge-to-mass ratio of the powder coating was determined to be +8.6µC/g with a device available as the Epping Q/m-meter. (Epping Q/m meter details and experiment details: a 400 mesh filter was used, with a blow-off pressure of 5 bar for 90' seconds)

A flexible, multilayer polyimide based, PCB was mounted on the rotating drum.

The rotation speed of the drum (i.e. coating speed) was set at 7 m/minute; the speed of the magnetic brush was set at 57 m/minute in the same direction as the drum. The doctor blade of the magnetic brush was adjusted to a distance of 2.0 mm to the magnetic roller. The magnetic pole was adjusted -10 degrees compared to the line between both rotating axes. The magnetic brush unit was set at a positive potential of 2.0 kV, whilst the rubber coated metal drum was grounded, resulting in a development potential of +2.0 kV. After passing the magnetic brush unit one time the PCB was fully coated on both the cupper and polyimide parts. The board was further processed under a medium wave IR lamp for 2 minutes at 100°C to obtain a uniform continuous layer. In a next step the heated coating on the PCB was covered with a photomask and irradiated with UV-radiation having a strength of 1500 mJ/cm.. The unexposed areas were developed with aceton. The resulting solder mask had an average applied layer thickness of 40 µm. The coated PCB was dipped for 10 seconds into a 50/50 Pb/Sn molten solder of 260°C. The produced solder mask did not show any blisters, spots of delamination and peeling from the PCB surface.

### Example 4

The experimental set up as described in Example 1 was used to powder coat a FR-4 based PCB of 1 mm thickness. Due to its limited thickness, this PCB could be mounted around the rotating rubber drum. The PCB was cleaned with a cloth soaked in water to get rid of any residual charges due to handling of the PCB and to increase its surface conductivity.

The rotation speed of the drum (i.e. coating speed) was set at 3 m/minute; the speed of the magnetic brush was set at 57 m/minute in the same direction as the drum.

The magnetic brush unit was set at a positive potential of 2.5 kV, whilst the rubber coated metal drum was grounded, resulting in a development potential of +2.5 kV. After passing the magnetic brush unit one time the PCB was coated on both the cupper and plastic parts. In order to increase the applied layer thickness, the PCB was passed three times by the magnetic brush resulting in a relatively thickly applied coating layer.The board was further processed under a medium wave IR lamp for 2 minutes at 100°C to obtain a uniform continuous layer. In a next step the heated coating on the PCB was covered with a photomask and irradiated with UV-radiation having a strength of 1500 mJ/cm. The unexposed areas were developed with aceton. The resulting solder mask had an average applied layer thickness of 45 µm. The coated PCB was dipped for 10 seconds into a 50/50 Pb/Sn molten solder of 260°C. The produced solder mask did not show any blisters, spots of delamination and peeling from the PCB surface.

### Example 5

The experimental set up as described in Example 1 was used to powder coat a FR-4 based PCB of 1 mm thickness. The PCB was pretreated with a negatively charging corona discharge from a point-electrode set at 50 kV, for 5 seconds, at a distance of 20 cm from the PCB.

The rotation speed of the drum (i.e. coating speed) was set at 3 m/minute; the speed of the magnetic brush was set at 57 m/minute in the same direction as the drum.

The magnetic brush unit was set at a positive potential of 2.5 kV, whilst the rubber coated metal drum was grounded, resulting in a development potential of +2.5 kV. After passing the magnetic brush unit one time the PCB was well coated on both the cupper and plastic parts. The board was further processed under a medium wave IR lamp for 2 minutes at 100°C to obtain a uniform continuous layer. In a next step the heated coating on the PCB was covered with a photomask and irradiated with UV-radiation having a strength of 1500 mJ/cm. The unexposed areas were developed with aceton. The resulting solder mask had an average applied layer thickness of 55 µm. The coated PCB was dipped for 10 seconds into a 50/50 Pb/Sn molten solder of 260°C. The produced solder mask did not show any blisters, spots of delamination and peeling from the PCB surface.

### Example 6

A powder solder mask composition was prepared by premixing 554 g of unsaturated polyester Uralac ZW 3125 (DSM), 112 g of vinyl ether Uralac ZW3307 (DSM), 16 g of photoinitiator Lucirin TPO (BASF), 16g of photoinitiator Irgacure- 819 (Ciba ) , 6 g of surfactant BYK-361 (BYK Chemie), 181 g of modified Bisphenol A epoxy resin D.E.R.6508 with epoxy.eq. 380-420 and softening point 95-105 C (DOW), 5 g of benzoin (GCA Chemical) as a degassing agent, 22 g of Aerosil R972(Degussa), and 5 g of green pigment Hellogene Green (BASF)

The components were mixed and the mixture was extruded on a Prism Extruder at 168°C at 200 RPM. A clear extrudate was obtained without visible nonhomogeneous inclusions. After cooling of the extrudate, the extrudate was milled first in a hammer mill to a particle size < 3 mm and then fed into a fluidized bed mill (Condux CFS8), having a nozzle diameter of 4 mm. The material was milled with 5 bar air overpressure at 1900 rpm of the classifier wheel incorporated in the mill obtaining a powder with a median particle size of 90 µm and a X_{75,3}/X_{25,3} ratio of 2.3. A mixture as described in example 3 was prepared. The resulting charged powder had a charge-to-mass ratio of 11.5 µC/g. The obtained powder was applied onto a FR-4 circuit board from the magnetic brush unit from the LD-tester according to example 5. The board containing a layer of powder particles was heated for 90sec under an IR lamp to melt the powder at a temperature of 100 °C. The plate was exposed through a photomask (non-contact) to 1800 mJ/cm² from 5000 W metal halide lamp, developed with cyclohexanone, and then a thermal postcure was performed at 145° C for 10 min . Additional UV cure at a dose of 800mJ/cm² was applied when the board was still at elevated temperatures.

The solder mask thus formed on a printed circuit board was smooth, showing no spotty coating, bubble free, and covering the circuits and each corner of the circuit with proper thickness. The thickness was 45um on the 50um high on the circuits, and 40 um on each edge of the circuits. Test of the solder mask revealed no peeling off after dipping in a molten solder at 260 ° C for 10 seconds.

## Claims

1. A method of forming a solder mask on a printed circuit board using a powder paint composition, which method comprises the steps of
a charging powder paint particles in the presence of carrier particles
b feeding the charged powder paint particles with carrier particles to a transporter
c optionally transferring the charged powder paint particles from the transporter onto a transfer medium
d applying the powder paint particles to a printed circuit board to form a layer of powder paint particles
e irradiating the layer by subjecting the layer to ultra violet irradiation through a pattern mask to obtain partial or full cure of the exposed powder paint particles
f developing the layer with a medium which dissolves the region not irradiated by the ultraviolet rays.

2. The method according to claim 1, wherein step e comprises heating the layer to a temperature above the glass-transition temperature of the powder paint particles and irradiating the layer by subjecting the layer to ultra violet irradiation through a pattern mask to obtain partial or full cure of the exposed powder paint particles.

3. The method according to claim 1 or 2, wherein the method contains a step
g optionally completely curing the remaining irradiated portion of the layer on the printed circuit board at a temperature higher than the curing temperature of the powder paint composition.

4. The method according to anyone of claims 1-3, wherein the PCB is pretreated by wetting the surface of the PCB with a polar substance.

5. The method according to anyone of claims 1-3, wherein the PCB is pretreated with a corona discharge device.

6. The method according to claim 2-5, whereby step e comprises heating the layer to a temperature above the glass-transition temperature of the powder paint particles, partially curing of the layer of powder paint particles to a level whereby it becomes tack free, applying a photo mask on the layer of partially cured powder coating layer, irradiating the layer by subjecting the layer to ultra violet irradiation through a pattern mask to obtain partial or full cure of the exposed powder paint particles.
